# EUROPEAN PATENT APPLICATION

(11) **EP 2 323 469 A1**
(43) Date of publication of application: **18.05.2011**
(21) Application number: 10190979.4
(22) Date of filing: 12.11.2010
(51) Int. Cl.: H05K 7/20, H02M 7/00

(54) **Motor drive unit and vehicle including the same**

(30) Priority: 13.11.2009 KR 20090109898; 13.11.2009 KR 20090109901
(71) Applicant: LG Electronics, Inc., Seoul 150-721 (KR)
(72) Inventor: Lee, Dongcheol, Seoul 153-023 (KR); Lim, Junyoung, Seoul 153-023 (KR); Lee, Dongwoo, Seoul 153-023 (KR); Kim, Jungbum, Seoul 153-023 (KR); Park, Jinsoo, Seoul 153-023 (KR); Ryu, Seunghee, Seoul 153-023 (KR)
(74) Representative: Vossius & Partner

(57) **Abstract**

Disclosed is a motor drive unit. The motor drive unit includes a case, a capacitor provided in the case and generating heat, an inverter provided in the case and configured to convert Direct Current (DC) power into Alternating Current (AC) power, and a water cooling jacket provided in the case and configured to radiate heat generated by the inverter to the outside. The case includes a radiating plate to radiate the heat generated by the capacitor to the outside.

## Description

The present invention relates to a motor drive unit and a vehicle including the same, and more particularly, to a motor drive unit, which radiates heat, generated by a capacitor and an inverter, to the outside, and a vehicle including the motor drive unit.

The development of motorized vehicles has centered upon an internal combustion engine. Although vehicles are a necessity of modem life, they are a leading cause of environmental pollution and consume enormous amounts of energy, thus depleting finite natural resources. Nowadays, instead of such a vehicle that employs an internal combustion engine as a power source, an electric vehicle that employs electricity as power, a hydrogen fuel vehicle, and a hybrid vehicle that combines hydrogen fuel or electricity with an internal combustion engine have been developed and put to use.

An Electric Vehicle (EV) is designed to obtain power by driving an Alternating Current (AC) or Direct Current (DC) motor using a battery. The electric vehicle is broadly classified into a battery powered electric vehicle and a hybrid electric vehicle. In the battery powered electric vehicle, a motor is driven using power of a battery, and the battery is recharged as needed. In the hybrid electric vehicle, a battery is charged with electricity that is generated by operation of an engine, and in turn, an electric motor is driven using the electricity to drive the vehicle.

The hybrid electric vehicle may be classified into either a series type or a parallel type. In a series hybrid electric vehicle, mechanical energy output from an engine is converted into electric energy via a generator, and the electric energy is fed to a battery or a motor. Thus, such a series hybrid electric vehicle is always driven by a motor and is realized by adding an engine and a generator to a conventional electric vehicle for the sake of enhanced mileage. A parallel hybrid electric vehicle employs two power sources so as to be driven by a battery alone and by a gasoline or diesel engine alone, or by both the engine and the motor according to traveling conditions.

Recently, small, high output and high performance systems have been developed in accordance with the development of motor/control technologies. As an AC motor is substituted for a DC motor, the electric vehicle may achieve a remarkable enhancement in output and power performance (acceleration and maximum speed) and thus, is comparable to a gasoline vehicle. Also, higher revolutions per minute of the motor owing to higher output enable the motor to be lighter and smaller, resulting in a substantial reduction in the weight or volume of the motor.

If the motor to drive the electric vehicle and a motor drive unit to apply power to the motor fail to dissipate heat generated therefrom, the motor drive unit suffers from deterioration in efficiency, lifespan and reliability. Therefore, there is a need for a method to radiate heat generated by the motor drive unit.

Therefore, the present invention has been made in view of the above problems, and it is an object of the present invention to provide a motor drive unit, which radiates heat generated by a capacitor and an inverter to the outside, and a vehicle including the motor drive unit.

Objects of the present invention are not limited to the above mentioned object, and those skilled in the art will clearly understand other objects not mentioned above with reference to the following description.

In accordance with one aspect of the present invention, the above and other objects can be accomplished by the provision of a motor drive unit including a case, a capacitor provided in the case and generating heat, an inverter provided in the case and configured to convert Direct Current (DC) power into Alternating Current (AC) power, and a water cooling jacket provided in the case and configured to radiate heat generated by the inverter to the outside, wherein the case includes a radiating plate configured to radiate the heat generated by the capacitor to the outside.

In accordance with another aspect of the present invention, there is provided a motor drive unit including a case, a capacitor provided in the case and generating heat, a plate provided on at least a portion of the capacitor so as to receive the heat generated by the capacitor, a heat pipe provided at a portion of the plate so as to receive the heat transferred from the plate, and a water cooling jacket provided in the case and configured to radiate the heat transferred from the heat pipe to the outside.

In accordance with a further aspect of the present invention, there is provided a vehicle including a motor drive unit configured to convert DC power into AC power, a motor configured to be rotated upon receiving the AC power from the motor drive unit, and wheels configured to be rotated by the motor, wherein the motor drive unit includes a case, a capacitor provided in the case and generating heat, an inverter provided in the case and configured to convert DC power into AC power, and a water cooling jacket provided in the case and configured to radiate heat generated by the inverter to the outside, and wherein the case includes a radiating plate configured to radiate the heat generated by the capacitor to the outside.

The above and other objects, features and other advantages of the present invention will be more clearly understood from the following detailed description taken in conjunction with the accompanying drawings, in which:
FIG. 1 is a schematic view illustrating a chassis of a vehicle according to an embodiment of the present invention;
FIG. 2 is a block diagram illustrating a motor, a battery, and a motor drive unit according to an embodiment of the present invention;
FIG. 3 is a perspective view illustrating a motor drive unit and a vehicle including the same according to an embodiment of the present invention;
FIG. 4 is a front view of FIG. 3;
FIG. 5 is a perspective view illustrating a motor drive unit and a vehicle including the same according to a further embodiment of the present invention; and
FIG. 6 is a front view of FIG. 5.

Advantages and features of the present invention and measures to achieve them will be clearly understood with reference to the following detailed description of exemplary embodiments taken in conjunction with the accompanying drawings. The present invention may, however, be embodied in many alternate forms and should not be constructed as limited to the embodiments set forth herein. It should be understood that the embodiments are given only for clarity of the disclosure of the present invention to clearly inform those skilled in the art of the scope of the invention, and that the present invention will be defined by the claims alone. The same reference numbers will be used throughout the description to refer to the same or like parts.

Hereinafter, the present invention will be described in more detail with reference to the accompanying drawings that are given to explain a vehicle 1 according to the embodiments of the present invention.

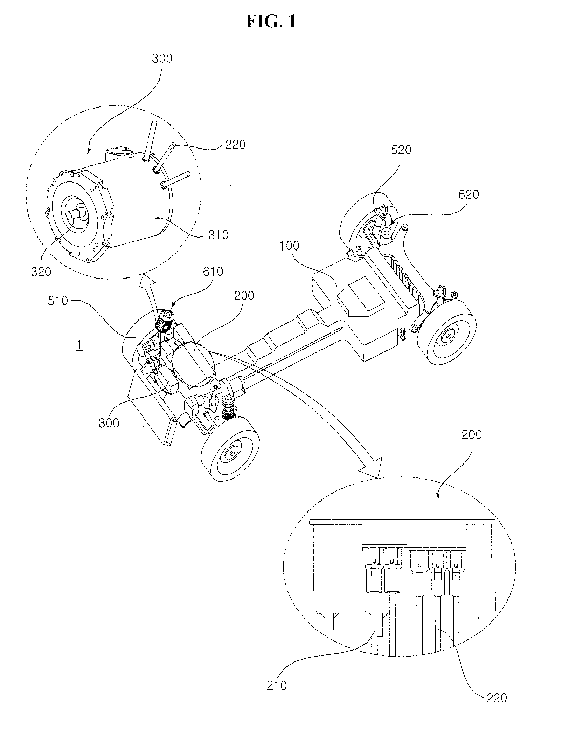

FIG. 1 is a schematic view illustrating a chassis of the vehicle 1 according to the embodiment of the present invention.

Referring to FIG. 1, the vehicle 1 according to the embodiment of the present invention includes a battery 100 to supply power, a motor drive unit 200 to receive the power from the battery 100, a motor 300 to be driven and rotated by the motor drive unit 200, front and rear wheels 510 and 520 to be rotated by the motor 300, and front wheel and rear wheel suspensions 610 and 620 to prevent road vibration from being transmitted to the chassis. In addition, a drive gear (not shown) may be provided to enable revolutions per minute of the motor 300 to be changed according to a gear ratio.

The battery 100 serves to supply power to the motor 300. The battery 100 may be a group of a plurality of unit cells. The plurality of unit cells may be managed by a Battery Management System (BMS) so as to provide a constant voltage. The battery 100 is preferably a chargeable or dischargeable secondary battery, but is not limited thereto.

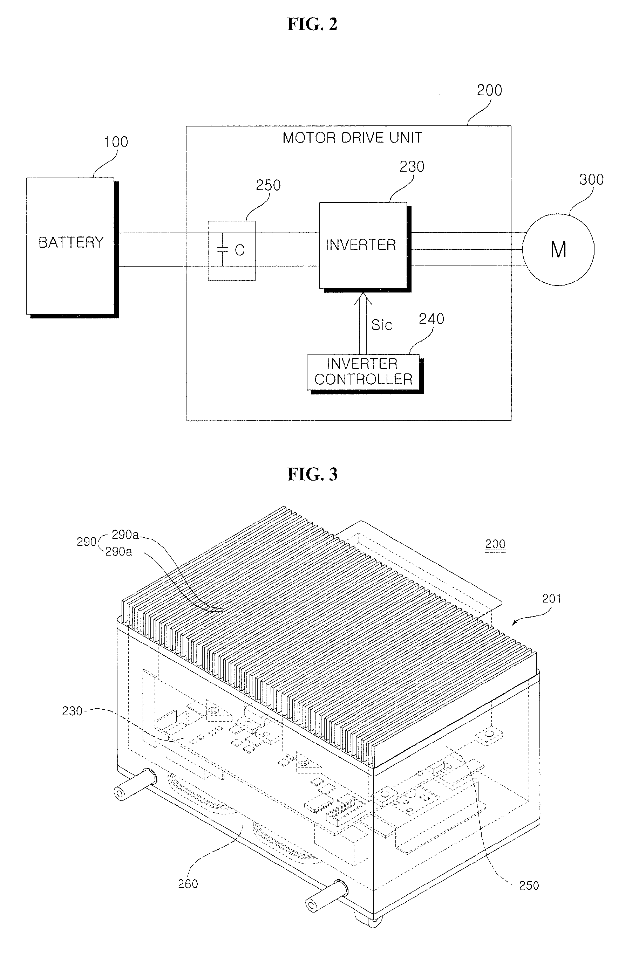

The motor drive unit 200 receives Direct Current (DC) power from the battery 100 via a DC power cable 210 thereof. The motor drive unit 200 converts the DC power supplied from the battery 100 into Alternating Current (AC) power to thereby supply the AC power to the motor 300. The converted AC power is preferably three-phase AC power. The motor drive unit 200 supplies the three-phase AC power to the motor 300 via AC power cables 220 thereof. Although FIG. 1 illustrates the motor drive unit 200 as including three AC power cables 220, a single cable may involve three cables. A detailed configuration of the motor drive unit 200 will be described hereinafter with reference to FIGS. 3 to 6.

The motor 300 includes a stationary stator 310, and a rotator 320 that rotates. The motor 300 is rotated upon receiving the AC power supplied from the motor drive unit 200. To apply the three-phase AC power from the motor drive unit 200 to the motor 300, the AC power cables 220 are connected to the motor 300. Once the three-phase AC power is applied to the motor 300, the stator 310 of the motor 300 creates a magnetic field using the three-phase AC power. The rotator 320 is rotated with repulsion between the magnetic field created by the stator 310 and a magnetic field created by a permanent magnet included in the rotator 320. In this way, the rotator 320 generates and transmits rotation energy to the drive gear (not shown) that will be described hereinafter.

The drive gear (not shown) may be provided at one side of the motor 300. The drive gear enables the rotation energy of the motor 300 to be converted according to a gear ratio. The rotation energy output from the drive gear is transmitted to the front wheels 510 and/or the rear wheels 520, enabling movement of the vehicle 1.

The front wheel suspensions 610 and the rear wheel suspensions 620 respectively support the front wheels 510 and the rear wheels 520 with respect to the chassis. The front wheel suspensions 610 and the rear wheel suspensions 620 are supported in a vertical direction by springs or attenuators, thereby preventing road vibration from being transmitted to the chassis.

The front wheels 510 may be further provided with a steering device (not shown). The steering device serves to control the orientation of the front wheels 510 so that a driver can steer the vehicle 1 in a desired direction.

FIG. 2 is a block diagram illustrating the motor 300, the battery 100, and the motor drive unit 200 according to the embodiment of the present invention.

Referring to FIG. 2, there are provided the battery 100 to supply power, the motor drive unit 200 to receive DC power from the battery 100 and apply converted AC power to the motor 300, and the motor 300 to be driven and rotated by the motor drive unit 200.

The motor drive unit 200 includes a capacitor 250 to smooth DC power supplied from the battery 100, an inverter 230 to convert the DC power transmitted from the capacitor 250 into AC power, and an inverter controller 240 to control the inverter 230.

The capacitor 250 is one kind of electric condenser and functions to smooth the DC power supplied from the battery 100. Specifically, the capacitor 250 smoothes the fluctuating DC power supplied from the battery 100. The smoothed DC power is supplied to the inverter 230. The capacitor 250 may be a DC-link capacitor.

The inverter 230 functions to convert DC power into AC power. The inverter 230 may be provided with a plurality of switching elements (not shown). Specifically, the inverter 230 converts the smoothed DC power into three-phase AC power having a predetermined frequency via On/Off motions of the switching elements, thereby applying the three-phase AC power to the motor 300.

The inverter 230 includes three pairs of upper arm and lower arm switching elements connected in parallel to one another, each pair of upper arm and lower arm switching elements being connected in series. The switching elements included in the inverter 230 perform On/Off motions based on switching control signals Sic from the inverter controller 240. Thereby, three-phase AC power having a predetermined frequency is supplied to the motor 300.

The inverter controller 240 provides the inverter 230 with the switching control signals Sic, in order to control the motions of the switching elements included in the inverter 230. The switching control signals Sic of the inverter controller 240 are switching control signals for Pulse Width Modulation (PWM) and are used to control the motions of the switching elements described above.

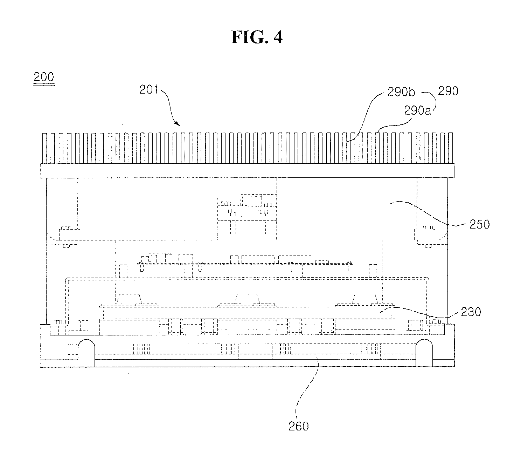

FIG. 3 is a perspective view illustrating the motor drive unit 200 and the vehicle 1 including the same according to the embodiment of the present invention, and FIG. 4 is a front view of FIG. 3.

Referring to FIGS. 3 and 4, the vehicle according to the embodiment of the present invention includes the motor drive unit 200 to convert DC power into AC power, the motor 300 to be rotated upon receiving the AC power from the motor drive unit 200, and the wheels 510 and 520 to be rotated by the motor 300.

The motor drive unit 200 includes a case 201 defining an external appearance of the motor drive unit 200, the capacitor 250 arranged to come into contact with an inner surface of an upper wall of the case 201 and generating heat, the inverter 230 arranged in a lower region of the case 201 and configured to convert DC power into AC power, and a water cooling jacket 260 arranged to come into close contact with the inverter 230 within the case 201 and configured to radiate heat generated by the inverter 230 to the outside. A portion of the case 201 that comes into contact with the capacitor 250 is provided with a radiating plate 290 to radiate the heat generated by the capacitor 250 to the outside.

The case 201 defines the external appearance of the motor drive unit 200 and has a hermetically sealed structure. The case 201 receives the above described elements therein and the interior of the case 201 is hermetically sealed to prevent introduction of air and moisture. The case 201 may be provided at a front position of the chassis and the shape of the case 201 may be changed according to the shape of the chassis. The case 201 is provided with the radiating plate 290 to radiate the heat generated by the capacitor 250 to the outside. The radiating plate 290 and the capacitor 250 will be described in detail hereinafter.

The capacitor 250 serves to store and smooth DC power as described above. The smoothed DC power is supplied to the inverter 230. The capacitor 250 may be a DC-link capacitor. The capacitor 250 stores high voltage DC power, and collision and vibrational motion of electrons stored in the capacitor 250 may generate heat. Since the generated heat moves in the hermetically sealed interior of the case 201 and deteriorates the operational efficiency of the motor drive unit 200, radiation of the heat is necessary. To this end, in the present embodiment, the heat is transferred to the radiating plate 290, which will be described hereinafter, to thereby be radiated to the outside.

The capacitor 250 may be arranged to come into contact with the inner surface of the upper wall of the case 201. Alternatively, the capacitor 250 may be arranged to come into contact with a side surface of the case 201 according to the shape and configuration of the case 201. Hereinafter, although the capacitor 250 is described as coming into contact with the inner surface of the upper wall of the case 201, the position of the capacitor 250 is not limited thereto.

The case 201 includes the radiating plate 290. The radiating plate 290 may be provided with a plurality of protruding radiating fins 290a and 290b. The plurality of radiating fins 290a and 290b increases a surface area of the radiating plate 290, thus increasing an air contact area of the radiating plate 290. The radiating plate 290 acts to radiate heat to air as the plurality of radiating fins 290a and 290b exchanges heat, generated by the capacitor 250, with outside air. In the present embodiment, the capacitor 250 comes into contact with the inner surface of the upper wall of the case 201, and thus, the heat generated by the capacitor 250 is indirectly transferred to the radiating plate 290 via the case 201 that comes into contact with the capacitor 250. According to the embodiments, the radiating plate 290 may come into contact with the capacitor 250 to directly receive the heat generated by the capacitor 250. The radiating plate 290 may also serve to radiate heat transferred from the case 201 to the outside.

The radiating plate 290 may be separately coupled to the case 201. According to the embodiments, a partial outer surface of the case 201 may be deformed to define the plurality of protruding radiating fins 290a and 290b. Also, the radiating plate 290 may be located at only a part of an outer surface of the case 201.

The radiating plate 290, according to the embodiments, may be placed on an outer surface of the upper wall of the case 201. In the present embodiment, the capacitor 250 is arranged to come into contact with the inner surface of the upper wall of the case 201, and thus, the radiating plate 290 is placed on the outer surface of the upper wall of the case 201. Alternatively, if the capacitor 250 comes into contact with either inner side surface of the case 201, the radiating plate 290 is located close to the inner side surface of the case 201. The radiating plate 290 may be located at an outer side surface of the case 201 according to the position of the capacitor 250.

The inverter 230 is arranged within the case 201 and serves to convert DC power into AC power. The inverter 230, as described above, generates heat during On/Off motions of the switching elements. The generated heat moves in the hermetically sealed interior of the case 201, deteriorating the operational efficiency of the inverter 230. Thus, radiation of the heat to the outside is necessary. To this end, the water cooling jacket 260 is arranged in the lower region of the case 201 so as to radiate heat transferred from the inverter 230 to the outside.

The inverter 230 may be arranged at the upper side of the water cooling jacket 260, to allow the water cooling jacket 260 to efficiently radiate the heat generated by the inverter 230 to the outside. As the heat generated by the inverter 230 is radiated to the outside, the efficiency of the motor drive unit 200 is enhanced. Also, the radiation of heat to the outside may increase the lifespan and reliability of the motor drive unit 200.

The inverter controller 240, according to the embodiments, may be arranged at the upper side of the water cooling jacket 260, together with the inverter 230, to allow the water cooling jacket 260 to efficiently radiate heat generated by the inverter controller 240 to the outside.

The water cooling jacket 260 is arranged within the case 201 and functions to radiate the heat transferred from the inverter 230 using the cooling water flowing therein. The water cooling jacket 260, according to the embodiments, may be arranged to come into contact with the inverter 230. If the water cooling jacket 260 comes into contact with the inverter 230, the heat generated by the inverter 230 is rapidly transferred to the water cooling jacket 260. The water cooling jacket 260 contains a cooling water flow path defined by a hollow or a pipe. The cooling water is cooled via heat exchange with outside air prior to being introduced into the water cooling jacket 260, and the heat transferred from the inverter 230 is transferred to the cooling water introduced into the water cooling jacket 260.

The cooling water, to which the heat from the inverter 230 has transferred, moves to the outside along the path, thereby radiating the heat to the outside via heat exchange with outside air. With this radiation of heat, the motor drive unit 200 is cooled and consequently, the efficiency of the motor drive unit 200 may be enhanced. The radiation of heat to the outside may also increase the lifespan and reliability of the motor drive unit 200.

The water cooling jacket 260 may be arranged in the lower region of the case 201, or may be arranged immediately below the case 201, according to the embodiments. The position of the water cooling jacket 260 may be changed according to the shape of the motor drive unit 200. Although the water cooling jacket 260 is described in the present embodiment as being arranged in the lower region of the case 201, the present invention is not limited thereto.

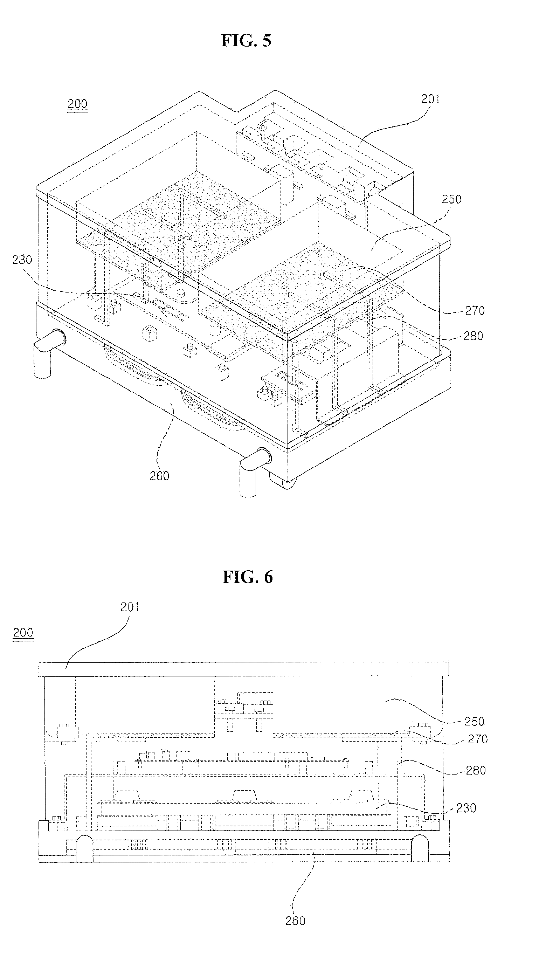

FIG. 5 is a perspective view illustrating the motor drive unit 200 and the vehicle 1 including the same according to the embodiment of the present invention, and FIG. 6 is a front view of FIG. 5.

Referring to FIGS. 5 and 6, the vehicle 1 according to the embodiment of the present invention includes the motor drive unit 200 to convert DC power into AC power, the motor 300 to be rotated upon receiving the AC power from the motor drive unit 200, and the wheels 510 and 520 to be rotated by the motor 300.

The motor drive unit 200 includes the case 201 defining the external appearance of the motor drive unit 200, the capacitor 250 arranged within the case 201 and generating heat, a plate 270 arranged to come into contact with a lower surface of the capacitor 250 so as to receive the heat generated by the capacitor 250, a heat pipe 280 provided at the plate 270 to receive the heat transferred from the plate 270, and the water cooling jacket 260 arranged within the case 201 and configured to receive and radiate the heat transferred from the heat pipe 280 to the outside.

The case 201 defines the external appearance of the motor drive unit 200 and has a hermetically sealed structure. The case 201 receives the above described elements therein and the interior of the case 201 is hermetically sealed to prevent introduction of air and moisture. The case 201 may be provided at a front position of the chassis and the shape of the case 201 may be changed according to the shape of the chassis.

The capacitor 250 serves to store and smooth DC power as described above. The smoothed DC power is supplied to the inverter 230. The capacitor 250 may be a DC-link capacitor. The capacitor stores high voltage DC power, and collision and vibrational motion of electrons stored in the capacitor 250 cause the capacitor 250 to generate heat. Since the generated heat moves in the hermetically sealed interior of the case 201 and deteriorates the operational efficiency of the inverter 230, radiation of the heat is necessary. To this end, in the present embodiment, the heat is transferred to the plate 270, which will be described hereinafter, to thereby be radiated to the outside.

The capacitor 250 may be arranged within the case 201, and according to the embodiments, may be arranged in an upper region of the case 201. Alternatively, the capacitor 250 may be arranged at the side surface of the case 201 according to the shape and configuration of the case 201. Hereinafter, although the capacitor 250 is described as being arranged in the upper region of the case 201, the position of the capacitor 250 is not limited thereto.

The plate 270 may be provided at a portion of the capacitor 250. The plate 270 contains all elements that come into contact with the capacitor 250. Although the plate 270 is preferably made of highly thermally conductive metal, the material of the plate 270 is not limited thereto.

The plate 270 may come into contact with a side surface or an upper surface of the capacitor 250 according to the position of the capacitor 250. The capacitor 250 may have a receiving portion indented in the surface thereof such that the plate 270 is received in the receiving portion so as to come into contact with the capacitor 250. Hereinafter, although the plate 270 is described as coming into contact with the lower surface of the capacitor 250, the position of the plate 270 is not limited thereto. The plate 270 comes into contact with the lower surface of the capacitor 250 so as to receive the heat generated by the capacitor 250.

The plate 270 is structured so as to maximize the contact area thereof with the lower surface of the capacitor 250. The contact area between the plate 270 and the capacitor 250 is directly proportional to the rate at which heat is transferred from the capacitor 250 to the plate 270. The plate 270 serves to receive heat from the capacitor 250 and transfer the heat to the heat pipe 280 that will be described hereinafter.

The heat pipe 280 is provided between the plate 270 and the water cooling jacket 260, which will be described hereinafter. The plate 270 is provided with the heat pipe 280 such that heat is transferred from the plate 270 to the heat pipe 280. The heat pipe 280 serves to transfer the heat to the water cooling jacket 260 that will be described hereinafter.

One side portion of the heat pipe 280 comes into contact with the plate 270 to directly receive heat from the plate 270. An opposite side portion of the heat pipe 280 comes into contact with the water cooling jacket 260 to transfer the heat to the water cooling jacket 260.

Specifically, a distal end of the one side portion of the heat pipe 280 may come into contact with the plate 270. Also, a part of an outer circumferential surface of the one side portion of the heat pipe 280 may be inserted into the plate 270 so as to come into contact with the plate 270. Similarly, a distal end of the opposite side portion of the heat pipe 280 may come into contact with the water cooling jacket 260. Also, a part of an outer circumferential surface of the opposite side portion of the heat pipe 280 may be inserted into the water cooling jacket 260 so as to come into contact with the water cooling jacket 260. The present invention includes all other configurations enabling heat transfer from the heat pipe 280 to the water cooling jacket 260.

In the embodiment of the present invention, a plurality of hollows is formed in the heat pipe 280 to receive volatile liquid. Although the volatile liquid received in the hollows may be methanol, acetone, water, mercury, and so on, the present invention is not limited thereto. The body of the heat pipe 280 may be made of cooper, stainless steel, ceramic, tungsten, and so on, although the present invention is not limited thereto.

The heat pipe 280 receives heat from the plate 270 and transfers the heat to the water cooling jacket 260. Once heat from the plate 270 is transferred to the one side portion of the heat pipe 280, liquid-phase fluid received in the heat pipe 280 is evaporated due to the transferred heat, and the evaporated gas-phase fluid moves to the opposite side portion of the heat pipe 280, thereby acting to transfer the heat to the water cooling jacket 260 that comes into contact with the opposite side portion of the heat pipe 280. The remaining fluid, from which the heat has been removed, is liquefied and returned to an original position, i.e. the one side portion of the heat pipe 280, thereby being ready to receive heat again.

The water cooling jacket 260 may be located inside or outside of the case 201, and serves to receive heat from the heat pipe 280 and radiate the heat to the outside. The water cooling jacket 260 contains a cooling water flow path defined by a hollow or a pipe. The cooling water is cooled via heat exchange with outside air prior to being introduced into the water cooling jacket 260, and the heat transferred from the inverter 230 is transferred to the cooling water introduced into the water cooling jacket 260.

The cooling water, to which the heat from the inverter 230 has transferred, moves to the outside along the path, thereby radiating the heat to the outside via heat exchange with outside air. With this radiation of heat, the motor drive unit 200 is cooled and consequently, the efficiency of the motor drive unit 200 may be enhanced. The radiation of heat to the outside may also increase the lifespan and reliability of the motor drive unit 200.

The water cooling jacket 260 may be located in an upper or lower region of the case 201, or may be located below the case 201, according to the embodiments. The position of the water cooling jacket 260 may be changed according to the shape of the motor drive unit 200. Although the water cooling jacket 260 is described in the embodiment of the present invention as being arranged in the lower region of the case 201, the present invention is not limited thereto.

The inverter 230, which serves to convert DC power into AC power, may be further provided below the capacitor 250. The inverter 230, as described above, generates heat during On/Off motions of the switching elements. The generated heat moves within the hermetically sealed interior of the case 201, deteriorating the operational efficiency of the inverter 230. Thus, radiation of the heat to the outside is necessary. To this end, the water cooling jacket 260 is provided in the lower region of the case 201 so as to receive the heat from the inverter 230 and radiate the heat to the outside.

The inverter 230 may be arranged close to the water cooling jacket 260 and, according to the embodiments, may be arranged at the upper side of the water cooling jacket 260. Although the inverter 230 will be described hereinafter as being arranged at the upper side of the water cooling jacket 260, the position of the inverter 230 is not limited thereto. Also, the inverter 230 may come into contact with the water cooling jacket 260. Once the inverter 230 comes into contact with the water cooling jacket 260, the water cooling jacket 260 rapidly radiates heat generated by the inverter 230. As the heat from the inverter 230 is radiated to the outside, the efficiency of the motor drive unit 200 is enhanced. Also, the radiation of heat to the outside may increase the lifespan and reliability of the motor drive unit 200.

Although not illustrated in FIGS. 5 and 6, the case 201 in FIGS. 5 and 6 may be further provided with the radiating plate 290 in the same manner as that in FIGS. 3 and 4. For example, if the capacitor 250 comes into contact with the inner surface of the upper wall of the case 201, the radiating plate 290 may include the plurality of protruding radiating fins 290a and 290b.

Also, although not illustrated in FIGS. 3 and 4, the case 201 in FIGS. 3 and 4 may be further provided with the plate 270 and the heat pipe 280 in the same manner as that in FIGS. 5 and 6. For example, the plate 270 may be provided to come into contact with the lower surface of the capacitor 250, and the heat pipe 280 may be provided between and come into contact with the plate 270 and the water cooling jacket 260 so as to transfer heat from the plate 270 to the water cooling jacket 260.

As is apparent from the above description of the present invention, a vehicle according to the present invention has one or more effects as follows.

Firstly, provision of a radiating plate may enable rapid radiation of heat generated by a capacitor to the outside.

Secondly, as the radiating plate is arranged to indirectly come into contact with the capacitor, heat may be more easily transferred from the capacitor to the radiating plate.

Thirdly, the radiating plate is provided with a plurality of protruding radiating fins, achieving an increased surface area for heat exchange with outside air.

Fourthly, there is provided a water cooling jacket through which cooling water flows, assuring easy transfer of heat from an inverter to the water cooling jacket.

Fifthly, the capacitor is provided with a plate to rapidly radiate heat generated by the capacitor. The plate has the effect of preventing overheating of the capacitor, thereby preventing deterioration in the lifespan and reliability of a motor drive unit.

Sixthly, the plate of the capacitor is connected to the water cooling jacket via a heat pipe. The heat pipe may enable rapid transfer of heat from the plate to the water cooling jacket.

Seventhly, as the water cooling jacket achieves rapid dissipation of heat generated by the inverter, i.e. rapid cooling of the inverter, it is possible to increase the lifespan and reliability of the inverter.

Eighthly, the water cooling jacket is arranged to come into contact with the inverter so as to directly receive and radiate the heat generated by the inverter to the outside, enabling rapid dissipation of the heat generated by the inverter.

## Claims

1. A motor drive unit comprising:
a case (201);
a capacitor (250) provided in the case (201) and generating heat;
an inverter (230) provided in the case (201) and configured to convert Direct Current (DC) power into Alternating Current (AC) power; and
a water cooling jacket (260) provided in the case (201) and configured to radiate heat, generated by the inverter (230), to the outside,
wherein the case (201) includes a radiating plate (290) configured to radiate the heat, generated by the capacitor (250), to the outside.

2. The motor drive unit according to claim 1, wherein the radiating plate (290) includes a plurality of protruding radiating fins (290a and 290b).

3. The motor drive unit according to claim 1 or 2, wherein the radiating plate (290) is placed on an outer surface of an upper wall of the case (201).

4. The motor drive unit according to any one of claims 1 to 3, wherein the capacitor (250) comes into contact with an inner surface of the upper wall of the case (201).

5. The motor drive unit according to any one of claims 1 to 3, wherein the capacitor (250) comes into direct contact with the radiating plate (290).

6. The motor drive unit according to any one of claims 1 to 4, wherein the water cooling jacket (260) radiates the transferred heat to the outside via movement of cooling water therein.

7. The motor drive unit according to any one of claims 1 to 6, wherein the inverter (230) is arranged below the capacitor (250).

8. The motor drive unit according to any one of claims 1 to 7, wherein the inverter (230) is provided at the upper side of the water cooling jacket (260) and generates heat, and the water cooling jacket (260) radiates the heat transferred from the inverter (230) to the outside.

9. The motor drive unit according to any one of claims 1 to 8, further comprising:
a plate (270) provided on at least a portion of the capacitor (250) so as to receive the heat generated by the capacitor (250); and
a heat pipe (280) provided at a portion of the plate (270) so as to receive the heat transferred from the plate (270).

10. The motor drive unit according to claim 9, wherein the plate (270) is provided at a lower surface of the capacitor (250).

11. The motor drive unit according to claim 9, wherein the capacitor (250) has a receiving portion indented in the surface thereof configured to receive plate (270) therein.

12. The motor drive unit according to claim 9 or 10, wherein the heat pipe (280) is provided between the plate (270) and the water cooling jacket (260) such that one side portion of the heat pipe (280) comes into contact with the plate (270) and an opposite side portion of the heat pipe (280) comes into contact with the water cooling jacket (260).

13. A vehicle comprising:
a motor drive unit (200) according to any of claims 1 to 12, configured to convert DC power into AC power;
a motor (300) configured to be rotated upon receiving the AC power from the motor drive unit (200); and
wheels (510 and 520) configured to be rotated by the motor (300).
